# EUROPÄISCHE PATENTSCHRIFT

(11) **EP 2 369 032 B1**
(45) Veröffentlichungstag und Bekanntmachung des Hinweises auf die Patenterteilung: **22.08.2012**
(21) Anmeldenummer: 10157794.8
(22) Anmeldetag: 25.03.2010
(51) Int. Cl.: C23C 14/12, C23C 14/22

(54) **Verfahren zur Herstellung farbiger Oberflächen**
Method of producing coloured surfaces
Procédé de fabrication de surfaces colorées

(43) Veröffentlichungstag der Anmeldung: 28.09.2011
(73) Patentinhaber: Odelo GmbH, 71409 Schwaikheim (DE)
(72) Erfinder: Keicher, Lukas, 70182 Stuttgart (DE); Pavlou, Michael, 71546 Aspach (DE); Müller, Otto, 73344 Gruibingen (DE)
(74) Vertreter: Benninger, Johannes

(56) Entgegenhaltungen:
- EP-A2- 1 643 005
- DE-A1-102004 060 481
- DE-C1- 19 515 172

## Beschreibung

Die Erfindung betrifft ein Verfahren gemäß dem Oberbegriff des Anspruchs 1.

Das menschliche Auge ist in der Lage, eine strukturlos erscheinende Partie des Gesichtsfelds von einer bei einäugiger Beobachtung mit unbewegtem Auge angrenzenden, ebenfalls strukturlosen Partie allein anhand der Farbe zu unterscheiden. Aufgrund dieser Fähigkeit des menschlichen Auges ist es von besonderer Bedeutung für die Technik, Lichtfarben und Körperfarben erzeugen zu können, von denen ein bestimmter Farbeindruck für das menschliche Auge ausgeht.

Ganz grundsätzlich muss bei Körperfarben zwischen Aufsichtsfarben und Durchsichts- bzw. Transparenzfarben unterschieden werden. Erstere werden durch den spektralen Remissionsgrad β_{λ} beschrieben, die anderen durch den spektralen Transmissionsgrad τ_{λ}. Körperfarben ändern die spektrale Zusammensetzung von Umgebungslicht entsprechend ihres Transmissions- und Remissionsverhaltens, wobei Durchsichtsfarben, die von durchsichtigen oder durchscheinenden Körpern ausgehend wahrgenommen werden, unter gewissen Bedingungen als Lichtfarbe wirken können.

Zur Herstellung einer Körperfarbe ist bekannt, die gewünschte Körperfarbe erzeugende Farbmittel, beispielsweise Pigmente, Farbstoffe, Färbelösungen, färbende Anstrichmittel oder dergleichen auf eine Oberfläche eines Objekts aufzutragen, von der ein bestimmter Farbeindruck ausgehen soll. Im nachfolgenden wird eine solche Oberfläche, von der ein bestimmter Farbeindruck ausgeht, als eine farbige Oberfläche bezeichnet.

So ist beispielsweise zur Herstellung farbiger Oberflächen bekannt, Farbmittel in Form von z.B. Lacken beispielsweise mittels einer Sprühdüse unter Zuhilfenahme von Druckluft oder einem anderen geeigneten gasförmigen Medium zu einem feinen Nebel zu zerstäuben und in einem mehr oder weniger gerichteten Strahl auf eine Oberfläche zu richten, wo sich die Nebeltropfen mehr oder minder zufällig, beispielsweise in Abhängigkeit von einer Relativanordnung von Sprühdüse und Oberfläche oder von einer Relativbewegung zwischen Sprühdüse und Oberfläche, als Lack- bzw. Farbschicht mit lokal abweichender Schichtdicke niederschlagen. Der Vorgang kann beliebig oft wiederholt werden, bis eine gewünschte Gesamtdicke der Farbschicht erreicht ist. Das Lackieren erfolgt hierbei beispielsweise in einem Reinraum unter Umgebungsbedingungen, bei denen normaler Atmosphärendruck und ebenso normale Umgebungstemperatur sowie Luftfeuchtigkeit herrschen.

Soll die farbige Oberfläche als Aufsichtsfarbe dienen, so werden mit dem bekannten Verfahren gute Oberflächenqualitäten erzielt, indem in einem oder in mehreren Durchgängen insgesamt eine Farbschicht ausreichender Gesamtdicke erzeugt wird, von der ein bestimmter Farbeindruck ausgeht.

Anders verhält es sich, wenn die farbige Oberfläche als Durchsichtsfarbe dienen soll. Beispiele für Gegenstände mit farbigen Oberflächen als Durchsichtsfarben sind Reflektoren, Licht- und Optikscheiben von Kraftfahrzeugleuchten. Bei Reflektoren kommt es beispielsweise aus gestalterischen Gründen vor, dass von einer durch physikalische Gasphasenabscheidung (Physical Vapour Deposition, PVD), wie etwa durch Bedampfen oder durch Sputtern, mit einer reflektierenden Beschichtung, beispielsweise einer Metallschicht, versehenen Oberfläche ein bestimmter Farbeindruck ausgehen soll. Auch bei Licht- und/oder Optikscheiben können solche Farbeindrücke aus den unterschiedlichsten Gründen erwünscht sein.

Das zuvor beschriebene Lackieren wird zwar auch zur Herstellung farbiger Oberflächen als Durchsichtsfarbe verwendet, hat dort allerdings den Nachteil, dass der Farbeindruck der so hergestellten farbigen Oberflächen nicht gleichmäßig ist. Der Grund hierfür ist, dass die durch Lackieren erzeugten, in einem oder mehreren Durchgängen hergestellten Farbschichten in sich abweichende Schichtdicken aufweisen. Beispielsweise kann es bei der Herstellung beispielsweise freigeformter, nicht ebener und beispielsweise durch ein Beschichtungsverfahren veredelter, farbiger Oberflächen durch Lackieren zur Bildung von Tropfnasen kommen. Zusammengefasst kann beim Lackieren weder eine exakte, reproduzierbare Schichtdicke der Lackschicht eingestellt werden, noch kann dadurch eine konstante Dicke innerhalb einer Lackschicht sichergestellt werden. Dies spielt als Aufsichtfarbe keine besonders große Rolle, weil hierzu in einem oder in mehreren Durchgängen eine derart große Gesamtdicke der Farbschicht erzeugt werden kann, dass von der farbigen Oberfläche überall derselbe Farbeindruck ausgeht. Bei als Durchsichtfarbe vorgesehenen Lackschichten können jedoch nicht beliebig dicke oder beliebig viele Farbschichten aufgetragen werden, wodurch in der Aufsummierung zur Gesamtdicke unterschiedliche Schichtdicken in den einzelnen Farbschichten ausgeglichen werden könnten, weil die höchstmögliche Gesamtdicke durch den Umstand begrenzt ist, dass die Farbschicht noch transparent sein soll. Bei durch Lackieren hergestellten farbigen Oberflächen als Durchsichtfarben gibt es dadurch Bereiche mit dünnerer und dickerer Schichtdicke, von denen unterschiedliche Farbeindrücke für das menschliche Auge ausgehen.

Denkbar wäre ferner die Erzeugung einer farbigen, mittels PVD hergestellten, veredelten Oberfläche. Zur farblichen Gestaltung könnte beispielsweise das Target- bzw. Ausgangsmaterial für das Sputtern bzw. Bedampfen entsprechend einem gewünschten Farbeindruck gewählt, oder dem Target- bzw. Ausgangsmaterial Farbmittel, etwa Farbe oder Farbpigmente, beigemengt werden. So ist beispielsweise durch DE 11 2008 000 252 T5 Sputtern im Allgemeinen bekannt, durch DE 11 2006 003 106 T5 ein Sputter-Target zur Oberflächenveredlung eines transparenten Werkstücks und durch DE 69 027 590 T2 Sputtern auf Siliziumdioxidbasis bzw. Quarz.

Nachteilig hieran wäre zum Einen die nur eingeschränkte farbliche Gestaltungsmöglichkeit wegen der Eigenfärbung des Target- bzw. Ausgangsmaterials und zum Anderen eine nicht zufriedenstellende und für technische Anwendung etwa bei der Herstellung von Leuchten für Kraftfahrzeuge nicht geeignete Farbreinheit und Gleichmäßigkeit der Farbe und des Farbeindrucks.

Durch DE 10 2004 060 481 A1 ist ein Verfahren zur Herstellung farbiger Oberflächen bekannt. Das Verfahren sieht ein Einbringen eines mit einer farbigen Oberfläche zu versehenden Bauteils in eine Vakuumkammer, eine Evakuierung der Vakuumkammer, ein Einbringen eines Farbmittel umfassenden Ausgangsmaterials unter Übergang in die Gasphase in die Vakuumkammer und einen Niederschlag des auf die Oberfläche gelenkten Ausgangsmaterials unter Resublimation bzw. Deposition des gasförmigen Ausgangsmaterials zu einer die farbige Oberfläche erzeugenden Schicht vor. Der Übergang in die Gasphase findet durch Verdampfen unter Wärmezufuhr statt.

Durch EP 1 634 005 A2 ist ein Verfahren zur Herstellung farbiger Nanoschichten mittels Plasmaentladung bekannt. Dabei ist eine Farbpartikel enthaltene Strömung einer gasförmigen Phase auf die farbig herzustellende Oberfläche gerichtet. Die Farbpartikel werden von der gasförmigen Phase der Strömung mitgerissen.

Durch DE 195 15 172 C1 ist ein Verfahren zur Herstellung farbiger Oberflächen bekannt, bei dem mittels eines Detektors, der von der farbig zu beschichtenden Oberfläche reflektiertes Licht erfasst, ein Verdampfer gesteuert wird, welcher sich auf der farbig herzustellenden Oberfläche niederschlagendes Ausgangsmaterial verdampft. Wird der Verdampfer abgeschaltet, ist der Herstellungsvorgang abgeschlossen. Dies geschieht, wenn der Detektor eine ausreichende Schichtdicke der Beschichtung der farbig herzustellenden bzw. hergestellten Oberfläche misst.

Das Problem unterschiedlicher bzw. ungleichmäßiger Farbeindrücke tritt verstärkt auf, je nachdem, ob Tageslicht bzw. natürliches Licht auf die farbige Oberfläche fällt, oder durch das oder die Leuchtmittel der Kraftfahrzeugleuchte ausgestrahltes Licht.

Aufgrund der Eingangs beschriebenen besonderen Fähigkeit des menschlichen Auges, Partien des Gesichtsfelds anhand der Farben zu unterscheiden, hat dies einen minderwertigen Qualitätseindruck zur Folge, was neben verminderter Akzeptanz zu erhöhtem Ausschuss und damit Ressourcenverbrauch und Kosten führt.

Der Erfindung liegt die Aufgabe zugrunde, ein Verfahren zur Herstellung insbesondere als Durchsichtsfarben dienender farbiger Oberflächen beispielsweise von Teilen für Kraftfahrzeugleuchten zu entwickeln.

Die Aufgabe wird gelöst durch die Merkmale des Anspruchs 1.

Demnach ist ein Verfahren zur Herstellung farbiger Oberflächen vorgesehen, mit den Verfahrensschritten:
- Einbringen eines mit einer farbigen Oberfläche zu versehenden Objekts bzw. Bauteils in eine Vakuumkammer,
- Evakuierung der Vakuumkammer,
- Einbringen eines Farbmittel umfassenden Ausgangsmaterials unter Übergang in die Gasphase in die Vakuumkammer,
- Lenkung des gasförmigen Ausgangsmaterials in der Vakuumkammer auf die herzustellende farbige Oberfläche, und
- Niederschlag des auf die Oberfläche gelenkten Ausgangsmaterials unter Resublimation bzw. Deposition des gasförmigen Ausgangsmaterials zu einer die farbige Oberfläche erzeugenden Schicht.

Die Lenkung des gasförmigen Ausgangsmaterials geschieht dabei durch ein Kraftfeld auf die herzustellende farbige Oberfläche. Das Kraftfeld umfasst ein elektrostatisches Feld, welches durch ein elektrisches Potential zwischen herzustellender farbiger Oberfläche und dem Ausgangsmaterial durch elektrische Kontaktierung einer Düse erzeugt wird, durch die das Ausgangsmaterials unter Übergang in die Gasphase in die Vakuumkammer eintritt.

Das Kraftfeld kann darüber hinaus ein elektromagnetisches und/oder ein magnetisches Feld umfassen.

Anschließend kann das Bauteil bzw. Objekt der Vakuumkammer wieder entnommen werden.

Erfindungsgemäß wird eine farbige Oberfläche hergestellt, indem ein mit einer solchen Oberfläche zu versehendes Objekt bzw. Bauteil in eine Vakuumkammer eingebracht wird oder bereits z.B. wegen eines vorherigen Oberflächenveredelungsschritts eingebracht ist, und anschließend unter Vakuum eine vorzugsweise transparente Schicht aufgebracht wird. Das Ausgangsmaterial der im Vakuum aufgetragenen Schicht umfasst Farbmittel, z.B. Farbpigmente. Die Farbmittel können beispielsweise beigemischt sein.

Hierdurch erfolgt quasi ein Vakuumlackieren, wobei beim Austritt des Farbmittel umfassenden Ausgangsmaterials aus beispielsweise einer Düse in die Vakuumkammer ein Verdampfen bzw. ein Übergang in die Gasphase erfolgt. Hierdurch entsteht eine Wolke gasförmiger Moleküle des Ausgangsmaterials in der Vakuumkammer. Beispielsweise durch ein elektrisches Potential zwischen herzustellender farbiger Oberfläche und dem Ausgangsmaterial, z.B. durch elektrische Kontaktierung der Düse, durch die das Ausgangsmaterial in die Vakuumkammer eintritt, oder durch ein Magnetfeld, oder durch ein Elektromagnetfeld, kurz durch ein Kraftfeld, werden die gasförmigen Moleküle des Ausgangsmaterials auf die herzustellende farbige Oberfläche gelenkt. Dadurch wandern die gasförmigen Moleküle der Wolke des Ausgangsmaterials zum Bauteil und schlagen dort bevorzugt auf der farbig herzustellenden Oberfläche nieder. Durch die Verdampfung und den damit verbundenen Übergang in die Gasphase gefolgt von dem anschließenden Niederschlag auf der Oberfläche wird eine die farbige Oberfläche auf dem Bauteil erzeugende Schicht hergestellt, bei der eine reproduzierbar gleichmäßige und homogene Schichtdicke sichergestellt ist.

Vorteile der Erfindung ergeben sich unter anderem durch eine prozesssichere Herstellung farbiger Oberflächen beispielsweise in einem unmittelbar an einen PVD-Prozess, wie etwa einen Bedampfungs- oder Sputterprozess, anschließenden Verfahrensschritt. Die Erfindung stellt eine reproduzierbar gleichmäßige und homogene Schichtdicke sicher. Tropfnasen, wie sie beim herkömmlichen Lackieren auf Oberflächen von Bauteilen mit komplexen Geometrien, insbesondere auf unebenen Oberflächen immer entstehen, werden wirkungsvoll vermieden. Durch die gleichmäßige, homogene Schichtdicke wird zudem ein gleicher Farbeindruck innerhalb einer farbigen Oberfläche und zwischen verschiedenen farbigen Oberflächen sichergestellt, insbesondere bei als Durchsichtsfarben dienenden farbigen Oberflächen. Nachbehandlungen sowie Ausschuss von mit farbigen Oberflächen versehenen Bauteilen werden verringert.

Das Verfahren kann zur Herstellung farbiger Oberflächen sowohl als Durchsichts-, als auch als Aufsichtsfarben verwendet werden.

Bei der Schicht kann es sich um eine zur Passivierung auf eine farbig herzustellende Oberfläche des Bauteils aufzubringende, beispielsweise transparente Schicht handeln.

Vorzugsweise erfolgt nach der Evakuierung der Vakuumkammer und vor dem Einbringen eines Farbmittel umfassenden Ausgangsmaterials unter Übergang in die Gasphase in die Vakuumkammer eine Veredelung der farbig herzustellenden Oberfläche des Objekts bzw. Bauteils durch einen in der selben Vakuumkammer stattfindenden Prozess.

Die farbig herzustellende Oberfläche kann so bereits in einem vorher z.B. in der selben Vakuumkammer stattfindenden Prozess mit einer Veredelung versehen sein. Bei der Veredelung der farbig herzustellenden Oberfläche des Objekts bzw. Bauteils kann es sich beispielsweise um die Herstellung einer reflektierenden Beschichtung handeln. Bei dem in derselben Vakuumkammer stattfindenden Prozess zur Veredelung der farbig herzustellenden Oberfläche des Objekts bzw. Bauteils kann es sich beispielsweise um einen physikalischen Gasabscheidungsprozess (Physical Vapor Deposition; PVD) handeln. Ein grundlegender Unterschied gegenüber dem Stand der Technik ist hierbei, dass der Farbeindruck nicht durch den PVD-Prozess, beispielsweise eine Metallisierung, sondern durch eine im Anschluss an den PVD-Prozess hergestellte Schicht erzeugt wird. Die nach dem PVD-Prozess erfindungsgemäß hergestellte Schicht, von welcher ein gewünschter Farbeindruck ausgeht, kann gleichzeitig als Schutzschicht und/oder zur Passivierung der im PVD-Prozess hergestellten Beschichtung dienen.

Eine vorteilhafte Ausgestaltung der Erfindung sieht vor, dass Ausgangsmaterial zumindest einen Kunststoff oder ein Gemisch von Kunststoffen umfasst.

Alternativ oder zusätzlich kann das Ausgangsmaterial wenigstens einen metallischen Werkstoff oder ein Gemisch von metallischen Werkstoffen umfassen.

Die Erfindung wird nachfolgend anhand von Ausführungsbeispielen näher erläutert.

Ein erstes Ausführungsbeispiel sieht ein Verfahren zur Herstellung einer als Durchsichtsfarbe dienenden farbigen Oberfläche eines aus einem transparenten Werkstoff hergestellten Bauteils vor. Beispielsweise handelt es sich bei dem Bauteil um eine Licht- oder Optikscheibe einer Kraftfahrzeugleuchte, beispielsweise einer Kraftfahrzeugheckleuchte. Die Licht- oder Optikscheibe kann beispielsweise aus einem homogenen Werkstoff hergestellt sein. Zumindest ein Teil der Oberfläche soll einen vom verwendeten Werkstoff abweichenden Farbeindruck erzeugen. Da die Licht- bzw. Optikscheibe im in eine Kraftfahrzeugheckleuchte eingebauten Zustand einem unmittelbaren Einblick durch einen Betrachter ausgesetzt ist, ist es erforderlich, dass der Farbeindruck gleichmäßig ist. Da sich an einem Kraftfahrzeug von hinten betrachtet ferner in einem Abstand von weniger als einer Fahrzeugbreite eine weitere, gleichartige oder identische Kraftfahrzeugheckleuchte befindet, ist zudem erforderlich, dass der Farbeindruck reproduzierbar identisch ist.

Um diese Anforderungen zu erfüllen wird zumindest die mit der farbigen Oberfläche zu versehende Partie der Licht- bzw. Optikscheibe in eine Vakuumkammer eingebracht. Beispielsweise kann die Partie der Licht- bzw. Optikscheibe dabei selbst eine Wandung oder einen Teil einer Wandung der Vakuumkammer bilden. Alternativ ist denkbar, den verbleibenden Teil der Licht- bzw. Optikscheibe zu maskieren und die gesamte Licht- bzw. Optikscheibe in die Vakuumkammer einzubringen. Beispielsweise kann die Vakuumkammer eine Aufnahme für die Licht- bzw. Optikscheibe aufweisen, welche eine der Kontur der Licht- bzw. Optikscheibe folgt. Beispielsweise ist denkbar, dass die Aufnahme eine Öffnung vorsieht, in welche die Licht- bzw. Optikscheibe eingesetzt werden kann. Die Öffnung kann zur Verbindung der Vakuumkammer mit der Umgebung dienen, wobei die Öffnung durch die Licht- bzw. Optikscheibe verschlossen werden kann. In der Ausnehmung können eine oder mehrere Dichtungen angeordnet sein, um einen luftdichten Abschluss der Vakuumkammer gegenüber der Umgebung sicherzustellen. Nach dem Einbringen der mit der farbigen Oberfläche zu versehenden Partie der Licht- bzw. Optikscheibe in die Vakuumkammer wird die Vakuumkammer evakuiert. Der Unterdruck ist dabei vorzugsweise so bemessen, dass ein bei Umgebungsbedingungen beispielsweise flüssig vorliegendes und Farbmittel umfassendes Ausgangsmaterial bei Eintritt in die Vakuumkammer verdampft.

Nachdem der Unterdruck in der Vakuumkammer eingestellt ist, wird das bei Umgebungsbedingungen beispielsweise flüssig vorliegende, Farbmittel umfassende Ausgangsmaterial in die Vakuumkammer eingebracht, wobei es bei dessen Eintritt in die Vakuumkammer verdampft bzw. in die Gasphase übergeht. Hierdurch entsteht zunächst eine Wolke aus gasförmigen Molekülen des Ausgangsmaterials in der Vakuumkammer.

Die Wolke bzw. das die Wolke in der Vakuumkammer bildende gasförmige Ausgangsmaterial wird nunmehr auf die herzustellende farbige Oberfläche gelenkt. Dies kann einerseits zum Teil durch den beim Eintreten in die Vakuumkammer erhaltenen Impuls geschehen sowie andererseits durch ein Kraftfeld. Beispielsweise eignen sich hierfür elektrostatische, elektromagnetische oder magnetische Kraftfelder oder Kombinationen hiervon. Im Falle eines elektrostatischen Kraftfelds kann beispielsweise vorgesehen sein, dass das Bauteil zumindest an seiner farbig herzustellenden Oberfläche an ein erstes elektrisches Potential angeschlossen wird und beispielsweise eine Düse, durch welche das flüssige Ausgangsmaterial in die Vakuumkammer eingespritzt wird, mit einem zweiten elektrischen Potential verbunden wird, welches, von dem ersten elektrischen Potential verschieden ist. Die Wirkung eines solchen Kraftfelds auf die gasförmigen Moleküle des Ausgangsmaterials in der Wolke ist dabei homogen über die gesamte farbig herzustellende Oberfläche der Licht- bzw. Optikscheibe gesehen.

Dadurch wird das gasförmige Ausgangsmaterial auf die farbig herzustellende Oberfläche gelenkt und schlägt sich dort unter Resublimation bzw. Deposition zu einer die farbige Oberfläche erzeugenden Schicht nieder.

Anschließend wird die Licht- bzw. Optikscheibe wieder aus der Vakuumkammer entnommen.

In der Vakuumkammer erfolgt hierbei quasi ein Vakuumlackieren, wobei beim Austritt des Farbmittel, wie etwa Farbpigmente umfassenden Ausgangsmaterials aus der Düse in die Vakuumkammer ein Verdampfen bzw. ein Übergang in die Gasphase erfolgt und eine Wolke gasförmiger Moleküle des Ausgangsmaterials in der Vakuumkammer entsteht. Hierdurch wird kein zusätzliches Gas benötigt, um das Ausgangsmaterial zu zerstäuben bzw. zu vernebeln. Ferner wird eine feinere Verteilung in der dadurch in der Vakuumkammer entstehenden Wolke erreicht, als beim konventionellen Lackieren. Beim erfindungsgemäßen Vakuumlackieren wird eine Teilchengröße in der Wolke in der Größenordnung eines Moleküls erreicht, wohingegen nach dem Stand der Technik ein Nebel aus Tröpfchen erzeugt wird. Durch die Verdampfung und den damit verbundenen Übergang in die Gasphase gefolgt von dem anschließenden Niederschlag auf der Oberfläche wird außerdem eine die farbige Oberfläche auf der Licht- bzw. Optikscheibe erzeugende Schicht hergestellt, bei der eine reproduzierbar gleichmäßige und homogene Schicht- sowie Gesamtdicke sichergestellt ist.

Ein zweites Ausführungsbeispiel sieht ein Verfahren zur Herstellung einer ebenfalls als Durchsichtsfarbe dienenden farbigen Oberfläche beispielsweise eines Reflektors einer Kraftfahrzeugleuchte, beispielsweise eines Kraftfahrzeugscheinwerfers, einer Kraftfahrzeugheckleuchte, oder einer beispielsweise außenspiegelmontierten Wiederholblinkleuchte vor.

Ein solcher Reflektor wird beispielsweise hergestellt, indem zunächst ein Kunststoffteil beispielsweise durch Spritzgießen hergestellt wird, welches die Form des späteren Reflektors aufweist. Dieses Kunststoffteil muss anschließend wenigstens auf der die Reflexionsfläche bildenden Seite mit einer reflektierenden Beschichtung versehen werden. Die mit der Beschichtung veredelte Seite wird anschließend mit der als Durchsichtsfarbe dienenden farbigen Oberfläche versehen um zum einen eine der Durchsichtsfarbe entsprechende Lichtfarbe zu erzeugen und um zum anderen bei einer Draufsicht auf die Kraftfahrzeugleuchte eine Körperfarbe mit einem gewünschten Farbeindruck zu erhalten. Die Durchsichtsfarbe wird vorzugsweise durch eine transparente Kunststoffschicht oder auch durch metallische Werkstoffe oder Kombinationen hiervon gebildet.

Um einen solchen Reflektor herzustellen, ist vorgesehen, das beispielsweise durch Spritzgießen hergestellte Kunststoffteil auf seiner die Reflexionsfläche bildenden Seite mit einer mittels physikalischer Gasphasenabscheidung (Physical Vapour Deposition, PVD) hergestellten reflektierenden Beschichtung auf Metallbasis zu versehen. Bei dem PVD-Prozess handelt es sich beispielsweise um Bedampfen oder Sputtern. Hierzu wird das Kunststoffteil zunächst in eine Vakuumkammer eingebracht. Die Vakuumkammer wird anschließend evakuiert. Nach dem Evakuieren der Vakuumkammer wird zunächst die reflektierende Beschichtung durch einen an sich bekannten PVD-Prozess hergestellt. Hierzu wird ein Bedampfungsmaterial oder ein Sputtertarget eingesetzt, welches aus einem Werkstoff besteht, der bei Niederschlag auf einem Kunststoff eine die gewünschten reflektierenden Eigenschaften aufweisende Schicht bildet.

Nachdem die reflektierend Schicht durch einen metallischen Werkstoff hergestellt ist, ist es wünschenswert, diese anschließend beispielsweise durch eine transparente Kunststoffschicht oder auch metallischen Werkstoffen oder Kombinationen hiervon zu Passivieren. Nunmehr ist vorgesehen, in das Ausgangsmaterial der transparenten Kunststoffschicht Farbmittel einzubringen, welche bei fertigem Reflektor den oben beschriebenen Farbeindruck erzeugen, und dieses Ausgangsmaterial ebenfalls vorzugsweise in derselben Vakuumkammer unter Vakuum auf die Reflexionsfläche aufzutragen.

Hierzu verbleibt das mit der reflektierenden Beschichtung versehene Kunststoffteil in der Vakuumkammer und es wird das Farbmittel umfassende Ausgangsmaterial unter Übergang in die Gasphase in die Vakuumkammer eingebracht. Beispielsweise durch ein elektrostatisches Feld, welches dank der bevorzugt metallischen reflektierenden Beschichtung sehr einfach aufgebracht werden kann, wird das gasförmige Ausgangsmaterials in der Vakuumkammer auf die herzustellende farbige Oberfläche gelenkt und schlägt sich anschließend unter Resublimation bzw. Deposition zu einer die farbige Oberfläche erzeugenden Schicht nieder. Die Wirkung eines solchermaßen erzeugten elektrostatischen Felds auf die Moleküle des gasförmigen Ausgangsmaterials in der Vakuumkammer ist dabei homogen über die gesamte farbig herzustellende Oberfläche des Reflektors gesehen.

Anschließend kann der fertige, mit einer reflektierenden Beschichtung und mit einer farbigen Oberfläche versehene Reflektor der Vakuumkammer entnommen werden.

Das Verfahren zeichnet sich dadurch aus, dass die Herstellung farbiger Oberflächen durch Beimischung von Farbmitteln, wie etwa Farbpigmenten, in das Ausgangsmaterial der beispielsweise zur Passivierung der Beschichtung vorgesehenen und im Vakuum aufgetragenen, z.B. transparenten Schicht erfolgt.

Hierdurch können zugleich eine der Passivierung dienende Schutzschicht für die reflektierende Beschichtung, als auch eine farbige Oberfläche des Reflektors hergestellt werden. Die farbige Oberfläche hat hierbei eine reproduzierbare, gleichmäßige Schicht- und Gesamtdicke, so dass ein gleichmäßiger und auch gleicher Farbeindruck sichergestellt ist.

Die Erfindung umfasst demnach ein Verfahren zur Herstellung farbiger Oberflächen beispielsweise von mittels PVD hergestellten Beschichtungen. Bei dem Verfahren wird gegebenenfalls zunächst mittels PVD eine Beschichtung hergestellt. Die Beschichtung wird anschließend durch Auftragen einer Schicht im Vakuum passiviert. Diese Schicht ist vorzugsweise transparent und kann z.B. unter Verwendung von Kunststoff oder auch metallischen Werkstoffen oder Kombinationen hiervon hergestellt werden. Das Verfahren kennzeichnet sich dadurch aus, dass die Herstellung farbiger Oberflächen durch Beimischung von Farbmitteln, wie etwa Farbpigmenten, in das Ausgangsmaterial einer beispielsweise zur Passivierung der Beschichtung vorgesehenen und im Vakuum aufgetragenen, z.B. transparenten Schicht erfolgt.

Sich hieraus ergebende Vorteile sind eine prozesssichere Herstellung farbiger Oberflächen z.B. in einem unmittelbar an einen Bedampfungs- oder Sputterprozess anschließenden Verfahrensschritt. Es wird eine reproduzierbar gleichmäßige und homogene Schichtdicke der die farbige Oberfläche bildenden Schicht sichergestellt.

Die Erfindung ist insbesondere im Bereich der Herstellung von Leuchtmitteln, Leuchtzeichen und Leuchten für Kraftfahrzeuge sowie deren Komponenten gewerblich anwendbar.

## Patentansprüche

1. Verfahren zur Herstellung farbiger Oberflächen mit den Verfahrensschritten:
- Einbringen eines mit einer farbigen Oberfläche zu versehenden Bauteils in eine Vakuumkammer,
- Evakuierung der Vakuumkammer,
- Einbringen eines Farbmittel umfassenden Ausgangsmaterials unter Übergang in die Gasphase in die Vakuumkammer, und
- Niederschlag des auf die Oberfläche gelenkten Ausgangsmaterials unter Resublimation bzw. Deposition des gasförmigen Ausgangsmaterials zu einer die farbige Oberfläche erzeugenden Schicht,
**gekennzeichnet durch**, eine Lenkung des gasförmigen Ausgangsmaterials in der Vakuumkammer **durch** ein Kraftfeld auf die herzustellende farbige Oberfläche, wobei das Kraftfeld ein elektrostatisches Feld umfasst, welches **durch** ein elektrisches Potential zwischen herzustellender farbiger Oberfläche und dem Ausgangsmaterial **durch** elektrische Kontaktierung einer Düse, **durch** die das Ausgangsmaterials unter Übergang in die Gasphase in die Vakuumkammer eintritt, erzeugt wird.

2. Verfahren nach Anspruch 1, **dadurch gekennzeichnet, dass** das Kraftfeld ein elektromagnetisches Feld umfasst.

3. Verfahren nach Anspruch 1 oder 2, **dadurch gekennzeichnet, dass** das Kraftfeld ein magnetisches Feld umfasst.

4. Verfahren nach einem der vorhergehenden Ansprüche, **dadurch gekennzeichnet, dass** die Schicht passivierende Eigenschaften aufweist.

5. Verfahren nach einem der vorhergehenden Ansprüche, **dadurch gekennzeichnet, dass** die Schicht transparent ist.

6. Verfahren nach einem der vorhergehenden Ansprüche, **dadurch gekennzeichnet, dass** nach der Evakuierung der Vakuumkammer und vor dem Einbringen eines Farbmittel umfassenden Ausgangsmaterials unter Übergang in die Gasphase in die Vakuumkammer eine Veredelung der farbig herzustellenden Oberfläche des Bauteils durch einen in derselben Vakuumkammer stattfindenden Prozess erfolgt.

7. Verfahren nach einem der vorhergehenden Ansprüche, **dadurch gekennzeichnet, dass** das Ausgangsmaterial zumindest einen Kunststoff oder ein Gemisch von Kunststoffen umfasst.

8. Verfahren nach einem der vorhergehenden Ansprüche, **dadurch gekennzeichnet, dass** das Ausgangsmaterial wenigstens einen metallischen Werkstoff oder ein Gemisch von metallischen Werkstoffen umfasst.

9. Verfahren nach einem der vorhergehenden Ansprüche, **dadurch gekennzeichnet, dass** die mit der farbigen Beschichtung zu versehende Oberfläche des Bauteils eine reflektierende Oberfläche ist.

10. Verfahren nach Anspruch 9, **dadurch gekennzeichnet, dass** die reflektierende Oberfläche durch eine metallische reflektierende Beschichtung hergestellt ist.

11. Verfahren nach Anspruch 10, **dadurch gekennzeichnet, dass** das mit einer farbigen Oberfläche zu versehende Bauteil ein durch Spritzgießen hergestelltes Kunststoffteil ist, das auf seiner mit einer farbigen Oberfläche zu versehende Seite mit einer mittels physikalischer Gasphasenabscheidung (Physical Vapour Deposition, PVD) hergestellten reflektierenden Beschichtung auf Metallbasis versehen ist.

12. Verfahren nach Anspruch 11, **dadurch gekennzeichnet, dass** es sich bei dem PVD-Prozess um Bedampfen oder Sputtern handelt.

## Claims

1. Method for the production of colored surfaces comprising the following process steps:
- introduction of a component, the surface of which is to be colored, into a vacuum chamber;
- evacuation of the vacuum chamber;
- introduction of a starting material comprising a colorant into the vacuum chamber, with said starting material undergoing a phase transition to the gaseous state; and
- deposition of the starting material directed toward the surface by resublimation or by depositing the gaseous starting material to form a layer that creates the colored surface;
**characterized in that** the gaseous starting material is channeled within the vacuum chamber through a force field toward the surface that is intended to be colored, wherein said force field comprises an electrostatic field, which is generated by an electric potential between the surface to be colored and the starting material by electrically contacting a nozzle, through which the starting material enters into the vacuum chamber, with the starting material thereby undergoing a phase transition to the gaseous state.

2. Method according to claim 1, **characterized in that** the force field comprises an electromagnetic field.

3. Method according to claim 1 or 2, **characterized in that** the force field comprises a magnetic field.

4. Method according to one of the previous claims, **characterized in that** the layer has passivating properties.

5. Method according to one of the previous claims, **characterized in that** the layer is transparent.

6. Method according to one of the previous claims, **characterized in that** after evacuating the vacuum chamber and before introducing a starting material comprising a colorant into the vacuum chamber, with the starting material thereby undergoing a phase transition to the gaseous state, a finishing process is applied to the component's surface to be colored, with said finishing process being conducted in the same vacuum chamber.

7. Method according to one of the previous claims, **characterized in that** the starting material comprises at least one plastic material or a mixture of several plastic materials.

8. Method according to one of the previous claims, **characterized in that** the starting material comprises at least one metallic material or a mixture of several metallic materials.

9. Method according to one of the previous claims, **characterized in that** the component's surface, to which the colored coating is to be applied, is a reflecting surface.

10. Method according to claim 9, **characterized in that** the reflecting surface is produced by a metallic reflective coating.

11. Method according to claim 10, **characterized in that** the component, to which a colored surface is to be applied, is a plastic part manufactured by injection molding having a metal-based reflective coating on that side to which the said colored surface is to be applied, with said metal-based reflective coating being produced by physical vapor deposition (PVD).

12. Method according to claim 11, **characterized in that** the PVD process is performed by vaporizing or sputtering.

## Revendications

1. Procédé de réalisation de surfaces colorées, comprenant les étapes:
- mise en place d'un composant à revêtir d'une surface colorée, dans une chambre à vide,
- réalisation du vide dans ladite chambre à vide,
- introduction dans la chambre à vide, d'une matière de base comprenant des colorants, en passant en phase vapeur et
- dépôt de la matière de base dirigée sur la surface, avec résublimation ou bien déposition de la matière de base gazeuse pour obtenir une couche créant ladite surface colorée,
**caractérisé par** le fait de diriger ladite matière de base gazeuse, dans la chambre à vide, à travers un champ de forces sur la surface colorée à réaliser, ledit champs de forces comprenant un champ électrostatique qui est généré par un potentiel électrique entre la surface colorée à réaliser et la matière de base, par mise en contact électrique d'une buse par laquelle ladite matière de base entre dans la chambre à vide, en passant en phase vapeur.

2. Procédé selon la revendication 1, **caractérisé par le fait que** le champ de forces comprend un champ électromagnétique.

3. Procédé selon la revendication 1 ou 2, **caractérisé par le fait que** le champ de forces comprend un champ magnétique

4. Procédé selon l'une quelconque des revendications précédentes, **caractérisé par le fait que** ladite couche présente de propriétés passivantes.

5. Procédé selon l'une quelconque des revendications précédentes, **caractérisé par le fait que** ladite couche est transparente.

6. Procédé selon l'une quelconque des revendications précédentes, **caractérisé par le fait que**, après la réalisation du vide dans ladite chambre à vide et avant l'introduction -dans la chambre à vide- d'une matière de base comprenant des colorants, en passant en phase vapeur, on procède à un affinage de la surface colorée à réaliser dudit composant, au moyen d'un processus se déroulant dans la même chambre à vide.

7. Procédé selon l'une quelconque des revendications précédentes, **caractérisé par le fait que** ladite matière de base comprend au moins une matière plastique ou un mélange de matières plastiques.

8. Procédé selon l'une quelconque des revendications précédentes, **caractérisé par le fait que** ladite matière de base comprend au moins un matériau métallique ou un mélange de matériaux métalliques.

9. Procédé selon l'une quelconque des revendications précédentes, **caractérisé par le fait que** la surface du composant, qui est à munir du revêtement coloré est une surface réfléchissante.

10. Procédé selon la revendication 9, **caractérisé par le fait que** la surface réfléchissante est réalisée par un revêtement métallique réfléchissant.

11. Procédé selon la revendication 10, **caractérisé par le fait que** le composant à munir d'une surface colorée est une pièce en matière plastique fabriquée par moulage par injection qui, sur sa face à munir d'une surface colorée, est pourvue d'un revêtement réfléchissant à base métallique produit au moyen d'un dépôt physique par phase vapeur (physical vapour deposition, PVD).

12. Procédé selon la revendication 11, **caractérisé par le fait que** ledit processus PVD est l'évaporation ou la pulvérisation cathodique.
